# DEMANDE DE BREVET EUROPEEN

(11) **EP 2 719 740 A1**
(43) Date de publication de la demande: **16.04.2014**
(21) Numéro de dépôt: 13188003.1
(22) Date de dépôt: 10.10.2013
(51) Int. Cl.: C09K 9/00, C23C 14/20, C23C 14/24, G02F 1/15, G02F 1/361, B32B 17/10, G02B 5/20, B64G 1/54, B64G 1/58, F16L 59/08

(54) **SURFACE RADIATIVE**

(30) Priorité: 12.10.2012 FR 1202725
(71) Demandeur: Thales, 92200 Neuilly Sur Seine (FR); Université de Cergy-Pontoise, 95011 Cergy-Pontoise Cedex (FR)
(72) Inventeur: Dudon, Jean-Paul, 83143 LE VAL (FR); Chastaing, Evelyne, PALAISEAU 91120 (FR); Vidal, Frédéric, 78780 MAURECOURT (FR); Fabre-Francke, Isabelle, 92000 NANTERRE (FR); Aubert, Pierre-Henri, 95520 OSNY (FR); Chevrot, Claude, 78100 SAINT GERMAIN EN LAYE (FR); Teissier, Anne Sandra, 74000 ANNECY (FR)
(74) Mandataire: Esselin, Sophie

(57) **Abrégé**

L'invention a pour objet une surface radiative comportant :
- un film comprenant :
○ un réseau semi-interpénétré ou interpénétré d'un premier polymère conducteur ionique et d'un deuxième polymère conducteur électronique et électro-chrome ;
○ un électrolyte pour imprégner ledit réseau,

- ledit film comprenant une première face destinée à être en contact avec les rayonnements solaires, ladite première face étant recouverte d'une première couche métallique afin de diminuer l'absorptivité des rayonnements solaires.

L'invention a aussi pour objet un procédé d'élaboration de la surface radiative

## Description

L'invention concerne le contrôle thermique actif des engins spatiaux et plus particulièrement une surface radiative pour engin spatial. Et plus précisément, l'invention concerne un dispositif à émissivité variable apte à être utilisé comme surface radiative pour un engin spatial.

Le contrôle thermique vise essentiellement à garantir le maintien de la température des constituants d'un engin spatial dans un intervalle de températures compatible avec leurs caractéristiques. Il s'agit, notamment, d'éviter de dépasser des températures au-delà desquelles un matériau de l'engin spatial serait endommagé ou détruit, mais aussi, de rester dans un intervalle de températures permettant de garantir une durée de vie prédéterminée d'un composant électronique.

Il existe deux modes de gestion des échanges thermiques à bord d'engins spatiaux : un mode dit passif et un mode dit actif.

Le principe de gestion passive des échanges thermiques repose sur la loi de Stefan-Boltzmann selon laquelle la puissance totale rayonnée par unité de surface fait intervenir la température, des corps en présence, à la puissance 4 mais aussi les propriétés thermo-optiques des surfaces d'échanges telles que l'émissivité ε et l'absorptivité α.

L'émissivité ε d'un matériau est un nombre sans dimension compris entre 0 et 1, désignant la capacité d'un matériau à émettre de la chaleur par radiation.

L'absorptivité α d'un matériau désigne la capacité d'un matériau à transformer une énergie électromagnétique en une autre énergie.

Ainsi la gestion thermique passive des échanges thermiques utilise des matériaux, des revêtements ou des traitements de surface permettant d'obtenir certaines propriétés. Classiquement, les surfaces destinées à refroidir des équipements sont recouvertes de petits miroirs constitués de feuilles minces de silice argentée. On obtient ainsi une surface ayant un facteur d'émissivité élevé, autrement dit, une bonne capacité à émettre de la chaleur vers l'espace et un facteur d'absorptivité faible, autrement dit, une bonne capacité à réfléchir les rayonnements solaires.

Un inconvénient de ce type d'applications est qu'elles ne sont pas modulables et ne permettent pas de s'adapter à des changements d'environnement, un changement d'orientation du satellite par rapport au rayonnement solaire par exemple.

Une gestion active des échanges thermiques utilise notamment des réchauffeurs tels que des résistances thermiques. Les résistances thermiques se présentent généralement sous la forme de rubans ou de feuilles, généralement collés sur les surfaces que l'on souhaite réchauffer. Ces résistances sont commandées par un thermostat qui les met en route dès que la température est inférieure à une température préalablement fixée. Les dispositifs de type résistances thermiques requièrent de l'énergie. Or dans le cadre d'applications pour engins spatiaux, il est nécessaire de minimiser les quantités d'énergie embarquée à bord de ces engins.

Depuis plusieurs années, des dispositifs innovants de revêtement à émissivité variable se développent. Dans un environnement froid, l'émissivité est minimale de manière à conserver la chaleur générée par les équipements embarqués alors que dans un environnement chaud, l'émissivité est maximale de manière à évacuer l'énergie thermique vers l'extérieur.

Des matériaux inorganiques de type réseau de Bragg ont été utilisés, un réseau de Bragg étant un réflecteur de grande qualité. Il s'agit d'une structure dans laquelle alternent des couches de matériaux d'indices de réfraction différents, ce qui provoque une variation périodique de l'indice de réfraction effectif. A la frontière entre deux couches, il se produit une réflexion partielle des ondes. Pour des ondes dont la longueur d'onde est égale à environ quatre fois l'épaisseur optique d'une couche, les réflexions se combinent par interférences constructives et les couches agissent comme un miroir.

L'élaboration de ce type de matériau nécessite l'application de températures élevées, incompatibles avec des supports de polymères flexibles utilisés pour des surfaces radiatives.

Une deuxième innovation consiste à recouvrir des surfaces de polymères sensibles aux températures élevées de patchs formant un dispositif multicouche, ce concept multicouche pouvant comprendre jusqu'à 5 ou 7 patchs, seul un des patchs est à émissivité variable. Selon cette technologie, un électrolyte est introduit entre la surface de polymère et le patch réflecteur afin de permettre le phénomène d'électrochromisme.

Un inconvénient de cette technologie est le risque de fuite de l'électrolyte et la dégradation du matériau de polymère.

Un but de l'invention est d'élaborer un dispositif à émissivité variable capable de pallier les problèmes de mise en oeuvre évoqués précédemment. Selon l'invention, il est proposé une surface radiative comportant :
- un film comprenant :
   ○ un réseau semi-interpénétré ou interpénétré d'un premier polymère conducteur ionique et d'un deuxième polymère conducteur électronique et électro-chrome ;
   ○ un électrolyte pour imprégner ledit réseau,
- ledit film comprenant une première face destinée à être en contact avec les rayonnements solaires, ladite première face étant recouverte d'une première couche métallique afin de diminuer l'absorptivité des rayonnements solaires.

Avantageusement, la première couche métallique présente une épaisseur comprise entre environ quelques nanomètres et quelques dizaines de nanomètres

En l'espèce, les termes « polymère conducteur ionique » désignent un polymère comprenant éventuellement des groupements dit polaires comprenant notamment des fonctions -OH, -COOH, -CH₂-CH₂-O-, NH₂, favorisant le déplacement des ions. Par exemple, un groupement éthylène glycol est capable de chélater un cation affaiblissant l'interaction ionique entre l'anion et le cation et favorisant les déplacements des anions d'un cation chélaté à un autre.

Le groupe des polymères conducteurs ioniques comprend, notamment, la famille des polyalkyleoxides et la famille des polyacrylates et polyméthacrylates ainsi que la famille des jeffamines.

Les termes « polymère conducteur électronique » désignent un polymère comprenant éventuellement un enchaînement de carbones hybridés sp² avec des carbones hybridés sp³ formant un système conjugué dans lequel les électrons sont délocalisés.

Le groupe des polymères conducteurs électroniques et électrochromes comprend notamment la famille des polythiophènes, la famille des polyanilines, la famille des polypyrroles, la famille des poly-paraphénylène.

Les termes « réseau de polymère » désignent un ou plusieurs polymères réticulés dont les chaînes sont reliées entre elles par des liaisons covalentes.

Les termes « réseau interpénétré » ou RIP représente un assemblage d'au moins deux polymères réticulés l'un dans l'autre formant ainsi un ou plusieurs réseaux.

Les termes « réseau semi-interpénétré » ou s-RIP représente un assemblage comprenant au moins un polymère réticulé formant un réseau et au moins un polymère non réticulé, enchevêtré dans le premier réseau et ne formant pas de deuxième réseau.
Les termes « imbiber » ou « gonfler » seront utilisés indifféremment. Un réseau de polymère, un réseau de polymères interpénétrés ou semi-interpénétrés mis en présence d'un électrolyte ne se dissout pas, le solvant de l'électrolyte étant incapable de rompre les liaisons permettant une dissolution. L'électrolyte pénètre alors dans le matériau provoquant un gonflement mécanique de ce dernier qui se gorge d'électrolyte.

Dans le mode de réalisation proposé par l'invention, les électrodes sont directement incorporées dans un matériau, ce qui facilite la mise en oeuvre de la surface radiative comprenant ledit matériau et permet un meilleur écoulement des charges électrostatiques provenant du plasma environnant le satellite.

Ce type de technologie permet un meilleur contrôle thermique tout en consommant moins de puissance électrique et par voie de conséquence moins de masse embarquée due aux batteries.

Le premier polymère conducteur ionique comprend du polyoxyéthylène ou POE et le deuxième polymère conducteur électronique et électrochrome comprend du poly (3,4-éthylènedioxythiophène) ou PEDOT.

Le choix du réseau semi-interpénétré comprenant du POE et du PEDOT ou s-RIP POE/PEDOT permet une commutation électrochrome de la surface radiative en fonction de l'état d'oxydation du PEDOT. De plus, le PEDOT est un polymère connu pour avoir une bonne stabilité au cours des cycles d'oxydoréduction et une grande amplitude de variation de réflectivité entre son état oxydé et son état réduit.

Le s-RIP comprend en outre au moins une première couche métallique CM1 sur une première face en contact avec les rayonnements solaires.

Avantageusement la première couche CM1 comprend de l'or, de l'argent ou de l'aluminium.

Avantageusement, la première couche comprenant de l'or a une épaisseur comprise entre quelques nanomètres et quelques dizaines, et préférentiellement entre 2,5 nm et 21 nm.

L'ajout de la première couche métallique sur la face de la surface radiative en contact avec les rayonnements solaires permet de diminuer l'absorptivité α ce qui permet de préserver notamment le s-RIP des rayonnements solaires.

Le réseau interpénétré comprend en outre au moins une deuxième couche métallique sur sa deuxième face.

Avantageusement la deuxième couche métallique comprenant de l'or, de l'argent ou de l'aluminium.

Avantageusement, la deuxième couche comprenant de l'or a une épaisseur de quelques dizaines de nanomètres, et préférentiellement entre 27 et 50 nm.

L'ajout de la deuxième couche métallique permet d'augmenter la conductivité de surface du s-RIP POE/PEDOT facilitant ainsi la mise sous tension de la surface radiative.

L'électrolyte est un liquide ionique, avantageusement, le (1éthyl-3-méthyl-imidazolium bis (trifluorométhanesulfonyl) imide) ou EMITFSI.

Selon un autre aspect de l'invention, il est proposé un procédé d'élaboration d'une surface radiative tel que décrit précédemment.
Il comprend les étapes suivantes :
- l'élaboration d'un réseau semi-interpénétré ou interpénétré comprenant :
   ○ un premier réseau de polymère conducteur ionique et
   ○ un deuxième polymère ou réseau de polymère, conducteur électronique et électrochrome,
- l'élaboration par évaporation thermique de la première couche métallique sur la face du réseau en contact avec le rayonnement solaire,
- l'imprégnation du réseau par l'électrolyte.

Le procédé comprend en outre une étape d'élaboration d'une deuxième couche métallique sur la deuxième face de la surface radiative.

Les liquides ioniques sont des sels dont la température de fusion est inférieure à 100°C voire inférieure à 0°C, et dont la tension de vapeur est très basse, voire non mesurable, ce qui est un avantage important pour des applications spatiales.

L'invention sera mieux comprise à l'étude de quelques modes de réalisation décrits à titre d'exemples nullement limitatifs, et illustrés par des dessins annexés sur lesquels :
- La figure 1 représente les étapes de formation d'un réseau interpénétré et d'un réseau semi-interpénétré, selon un aspect de l'invention,
- La figure 2 représente schématiquement les différentes étapes de synthèse d'un réseau semi-interpénétré comprenant du POE et du PEDOT, selon un aspect de l'invention,
- La figure 3 représente un bâti de dépôt par évaporation thermique utilisé pour l'élaboration de la première et deuxième couche d'or sur les faces du s-RIP POE/PEDOT, selon un aspect de l'invention,
- la figure 4 est un diagramme représentant les variations de la réflectivité en fonction de l'épaisseur de la couche d'or déposée sur un s-RIP POE/PEDOT, selon un aspect de l'invention, et
- les figures 5a et 5b sont des diagrammes représentant les variations de réflectivité d'un s-RIP POE/PEDOT recouvert d'une couche comprenant de l'or d'une épaisseur de 6 nm et d'un s-RIP POE/PEDOT recouvert d'une couche comprenant de l'or d'une épaisseur de 27 nm, en fonction de l'état d'oxydation du PEDOT, selon un aspect de l'invention.

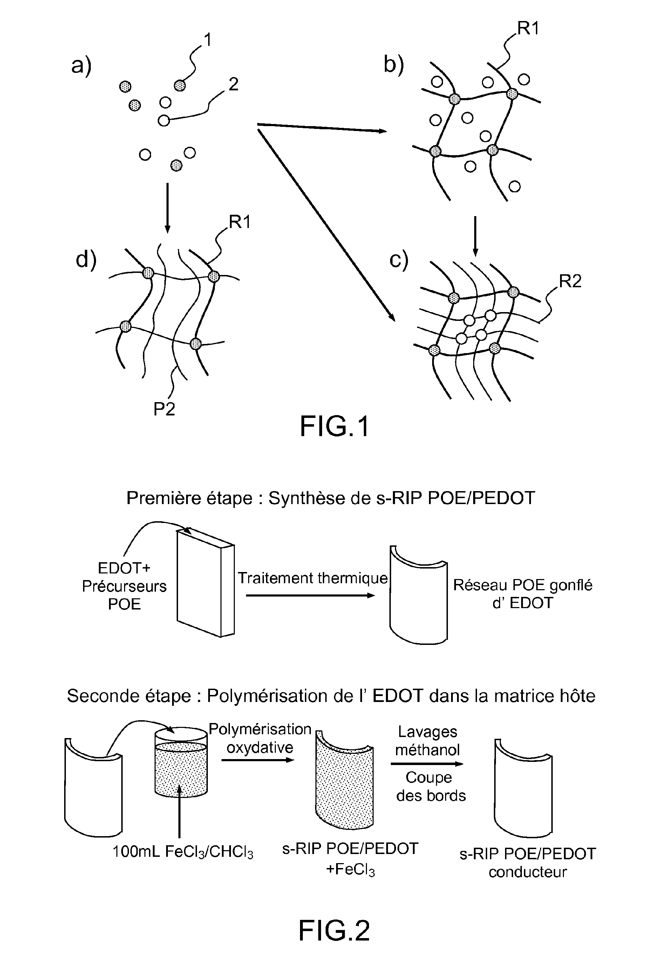

La figure 1 représente les étapes de formation d'un réseau interpénétré et d'un réseau semi-interpénétré. La figure 1a représente un mélange homogène en solution de monomères comprenant un monomère 1 et un monomère 2. La figure 1b représente un premier réseau R1 tridimensionnel d'un polymère comprenant des monomères 1, le réseau R1 tridimensionnel de polymère étant gonflé d'une solution comprenant les autres monomères 2. La figure 1c représente le premier réseau R1 et un deuxième réseau R2 de polymère comprenant les monomères 2. Le premier R1 et le deuxième R2 réseau sont enchevêtrés pour former un réseau interpénétré ou RIP.

Il est possible de réaliser un réseau interpénétré de manière séquentielle en deux étapes. Une première étape de formation d'un premier réseau et une deuxième étape de formation du deuxième réseau. Alternativement, il est possible de réaliser un réseau interpénétré en une seule étape de formation du premier et deuxième réseau.

La figure 1d représente un réseau semi-interpénétré s-RIP comprenant un premier réseau de polymère R1 comprenant des monomères 1 et un polymère comprenant les monomères 2, le polymère comprenant le monomère 2 n'étant pas sous la forme d'un réseau.
Ce type de structure RIP ou s-RIP permet un mélange stable de polymères dans lequel une synergie des propriétés des polymères peut être observée. La polymérisation des monomères peut être chimique ou électrochimique. Les polymérisations des monomères 1, 2 peuvent être réalisées de manière séquentielle ou simultanée.
L'élaboration d'une surface radiative comprenant un dispositif électrochrome recouvert sur au moins l'une de ses faces d'une couche métallique peut comprendre deux étapes : une première étape d'élaboration du dispositif électrochrome et une deuxième étape de réalisation des couches métalliques.

La figure 2 représente la première étape d'élaboration de la surface radiative selon un aspect de l'invention. Elle illustre schématiquement les principales étapes d'élaboration d'un réseau s-RIP semi-interpénétré comprenant du POE et du PEDOT s-RIP POE/PEDOT. Cette synthèse est décrite dans la demande de brevet internationale WO 2010/058108.

La synthèse de films minces de s-RIPs conducteurs présentant des propriétés d'électro-émissivité est effectuée en deux étapes principales.

La première étape de la synthèse consiste en l'élaboration d'un réseau de poly(oxyéthylène) POE contenant le monomère 3,4-éthylène dioxythiophène EDOT utilisé comme solvant et qui, par polymérisation, conduira au poly (3,4-éthylènedioxythiophène) PEDOT.

La matrice, en l'espèce le POE, est composée d'un réseau en trois dimensions dans lequel sont présentes des chaînes pendantes, une chaîne pendante étant une chaîne de polymère reliée au réseau de polymère par une seule liaison. Ces chaînes apportent un effet plastifiant au matériau. Suite à des mesures de conductivité ionique, le mélange de précurseur pour la formation de la matrice de POE a été optimisé. Un mélange comprenant du poly (éthylène glycol) méthacrylate méthyl éther) PEGM et du (poly (éthylène glycol) diméthacrylate) PEGDM permet d'obtenir un bon compromis entre les propriétés de conductivité ionique et les propriétés mécaniques de la matrice.

Le mélange des précurseurs comprend en outre un amorceur, le 2,2'-azobis-isobutyronitrile AIBN dont la masse représente 1 % de la masse totale de monomères constitutifs de la matrice de POE.

Le mélange est ensuite introduit à l'aide d'une seringue entre deux plaques de verre séparées par un joint de téflon, l'épaisseur du joint de téflon permettant de faire varier l'épaisseur du matériau s-RIP POE/PEDOT.

Le mélange comprenant les précurseurs du POE, de l'EDOT et de l'amorceur subit un traitement thermique à une température de 50°C. Après décomposition thermique de l'amorceur, les fonctions méthacrylate du PEGDM et du PEGM sont copolymérisées, conduisant à la formation du réseau sous la forme d'un film.

La solution permettant l'élaboration du POE comprend 2% en masse d'EDOT. Le film de POE ainsi formé est gonflé de monomère d'EDOT.

La seconde étape de la préparation de s-RIPs POE/PEDOT consiste à former le polymère conducteur électronique et électrochrome, en l'espèce le PEDOT. Les réseaux de POE contenant 2% en masse d'EDOT sont immergés dans d'une solution oxydante de chloroforme contenant du chlorure de fer FeCl₃ anhydre dont la concentration est de 0,25 mol.L⁻¹. La polymérisation est effectuée à une température comprise entre 30 et 50°C pendant une durée comprise entre 30 minutes et 2 heures. A la fin de cette polymérisation, les matériaux sont immergés successivement dans plusieurs bains de méthanol afin d'enlever l'excès de FeCl₃ et l'EDOT n'ayant pas été polymérisé.

Les dispositifs électrochromes organiques à base de réseau semi-interpénétré de polymères présentent des performances très prometteuses pour la modulation des échanges de chaleur dans les domaines de l'infrarouge et du visible par contrôle de l'émissivité. Ils peuvent être utilisés directement en tant que dispositif à émissivité variable. Toutefois deux orientations majeures de progrès semblent identifiées pour une application de surface radiative embarquée sur un engin spatial.

Alternativement, le polymère conducteur ionique peut être des dérivés de cellulose, des dérivés de polyméthacrylates d'alkyle ou des dérivés de nitrile butadiène, par exemple.

Alternativement, le polymère conducteur électronique et électrochrome peut être des dérivées de la polyaniline ou du poly(3,4-propylènedioxythiophène), par exemple.

Alternativement, le dispositif électrochrome peut comprendre un réseau interpénétré comprenant un polymère conducteur tel que des dérivés du polythiophène ou des dérivés du polypyrrole, par exemple, ces polymères pouvant se réticuler.

D'une part, il est nécessaire de réduire leur absorptivité α sans dégrader le contraste en émissivité dans la bande infrarouge.

D'autre part, il est nécessaire d'augmenter la conductivité électrique de surface du dispositif afin de faciliter la mise sous tension de ces dispositifs.

Il est proposé de déposer une première couche métallique sur la surface en contact direct avec les rayonnements solaires. Avantageusement, la couche métallique comprend de l'or, de l'argent ou de l'aluminium.

En l'espèce, la première couche métallique est déposée par une technique d'évaporation sous vide. D'autres techniques de dépôt vide peuvent être utilisées, notamment, la pulvérisation cathodique. La technique d'évaporation thermique consiste à chauffer un matériau par effet Joule sous un vide poussé, vaporisé le matériau va se déposer sur les échantillons à recouvrir.

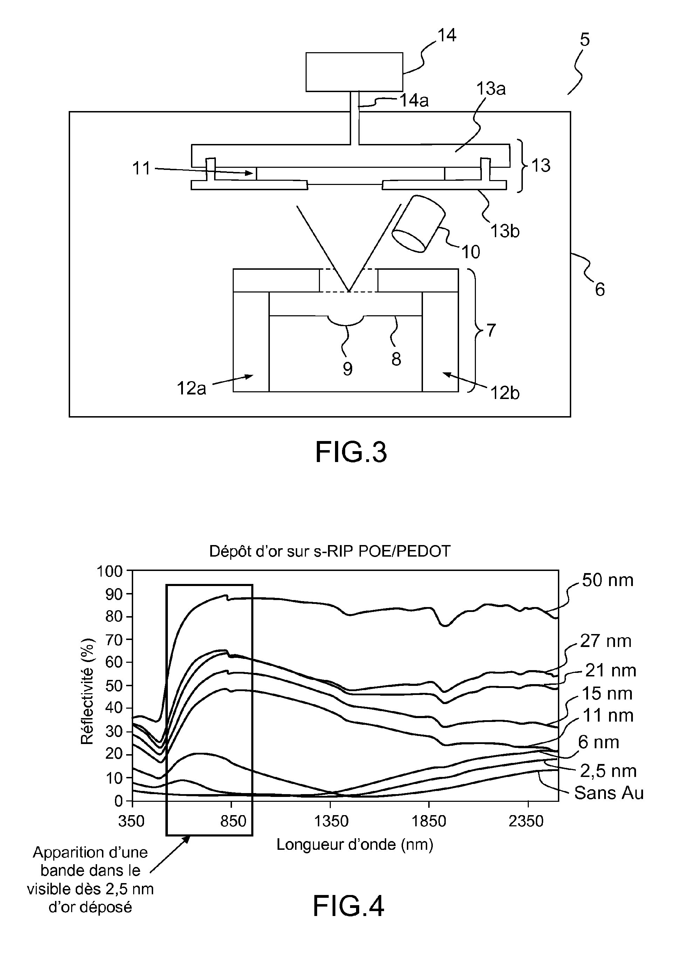

La figure 3 représente un bâti de dépôt métallique sous vide par évaporation thermique, de type « Edwards Auto 306 » (marque déposée).

Le bâti de dépôt est associé à une pompe à vide, non représentée sur la figure 3, l'enceinte de dépôt 6 pouvant atteindre des pressions de l'ordre de 10⁻⁶ à 10⁻⁷ torrs, l'ensemble des pièces du bâti comprenant du titane ou du tungstène.

Le bâti de dépôt comprend une source 7 comprenant un filament 8, le filament 8 étant généralement en forme de ruban plat qui comprend une déformation en forme de creuset 9 pouvant servir de réceptacle pour y déposer le métal, sous forme bâtonnets, à évaporer. Habituellement, le filament 8 comprend du tungstène, la température de fusion de ce matériau étant supérieure à la température d'évaporation des matériaux à déposer par évaporation thermique.

Afin de contrôler l'épaisseur des couches métalliques déposées, on utilise une microbalance à quartz 10. Le principe de celle-ci consiste à détecter la dérive de la fréquence d'oscillation du quartz par la modification de sa masse lors de la croissance de la couche déposée, le quartz étant positionné au plus près des échantillons 11 de façon à ce que le dépôt s'effectue aussi sur le quartz. La mesure de la masse de métal déposée est par conséquent une mesure électrique qu'il faut bien évidemment étalonner en fonction de la position de la microbalance à quartz par rapport aux échantillons. A chaque début d'expérience, la fréquence de référence est redéfinie. En mesurant le décalage de fréquence en fonction du temps, on peut aussi déterminer la vitesse de croissance des couches métalliques déposées.

Le filament de tungstène 8 est connecté à deux électrodes 12a, 12b entre lesquelles est appliquée une différence de potentiel ddE permettant de chauffer le filament 8. Le métal à déposer, en l'espèce l'or sous forme de bâtonnets est introduit dans le creuset 9 constitué par le filament 8.

Le s-RIP POE/PEDOT est inséré dans un porte-échantillon 13 qui comprend un support 13a comprenant de l'aluminium et un cache comprenant du cuivre. Le cache 13b est dimensionné de manière à obtenir un matériau final de forme carré de 3 cm de côté. Le porte échantillon 13 est fixé sur un support, le support étant fixé sur un axe 14a associé à un moteur 14 permettant la rotation des échantillons au cours du dépôt, permettant de déposer des couches métalliques homogènes en épaisseur.

Les dépôts d'or sont réalisés avec des conditions bien précises: de pression, de vitesse de rotation, de temps de dépôt, et dont dépend l'épaisseur des couches d'or déposée.
Une fois les échantillons 11, en l'espèce les s-RIP POE/PEDOT introduits à l'intérieur de l'enceinte 6, la pression de l'enceinte 6 est descendue jusqu'à des valeurs de l'ordre de 8.10⁻⁷ Torrs.
Une différence de potentiel ddE est appliquée entre les deux électrodes 12a, 12b. Cette différence de potentiel ddE correspond à des intensités de courant de l'ordre de 24 à 28 A.

Le filament de tungstène 8 est chauffé. Dans un premier temps, les bâtonnets d'or sont fondus puis évaporés. Au cours de l'évaporation la pression à l'intérieur de l'enceinte remonte jusqu'à environ 2.10⁻⁶ Torrs. La température des échantillons 11 reste sensiblement constante, de l'ordre de 25 à 26°C, ce qui évite la détérioration des s-RIPs POE/PEDOT.

Dans ces conditions expérimentales, la vitesse de dépôt est comprise entre 0,11 et 0,19 nm.s⁻¹.

La durée de métallisation par évaporation thermique est comprise entre 30 secondes et 5 minutes en fonction de l'épaisseur de la couche d'or souhaitée.

D'autres couches métalliques peuvent être superposées afin de limiter les effets destructeurs liés à d'autres types de rayonnements, notamment les rayonnements X ou gamma.

Une durée de refroidissement de l'ordre de 15 minutes est respectée avant de faire remonter la pression à l'intérieur de l'enceinte 6 du bâti et de sortir les échantillons.

La figure 4 représente un diagramme de réflectivité en fonction de la longueur d'onde pour différentes épaisseurs d'or déposées sur un s-RIP POE/PEDOT 11.

Les mesures de réflectivité de couche d'or d'épaisseur comprise entre 0 et 50 nm d'épaisseur sur un s-RIP POE/PEDOT montrent que la réflectivité augmente avec l'épaisseur des couches d'or sur tout le domaine du visible et de l'infrarouge.

Dans le domaine du visible, compris entre 400 et 700 nm, une augmentation de la réflectivité est d'observée en présence d'un dépôt d'or sur un s-RIP POE/PEDOT. L'augmentation de réflectivité dans le domaine du visible apparaît dès que l'on dépose une couche comprenant de l'or d'une épaisseur de 2,5 nm. En effet, en l'absence de dépôt de couche comprenant de l'or, la réflectivité est comprise entre 2 à 3 %. Lorsqu'on dépose une couche d'or de 2,5 nm d'épaisseur sur un semi-RIP POE/PEDOT, la réflectivité atteint près de 10 %. Lorsqu'on dépose une couche comprenant de l'or d'une épaisseur de 50 nm, la réflectivité est de l'ordre de 90%.

Dans le domaine de l'infrarouge, compris entre 780 et 2500 nm, la réflectivité augmente de la même façon avec l'augmentation de l'épaisseur de la couche d'or déposée sur les semi-RIPs.

Ces résultats montrent qu'il est possible de diminuer l'absorptivité α.

De nombreux essais ont permis de d'optimiser l'épaisseur de la première couche métallique en contact avec les rayonnements solaires de manière à diminuer au maximum le facteur α d'absorptivité du dispositif tout en limitant l'impact sur l'émissivité du dispositif électrochrome.

Avantageusement, une couche comprenant de l'or d'une épaisseur comprise entre 2,5 et 21 nm permet d'obtenir le meilleur compromis entre l'absorptivité et l'émissivité.

Par ailleurs, d'autres essais ont montré qu'une couche métallique comprenant de l'or ou de l'argent ou de l'aluminium sur la face qui n'est pas directement en contact avec les rayonnements solaires permet d'augmenter le conductivité de surface du dispositif électrochrome s-RIP POE/PEDOT permettant ainsi un meilleur contact électrique du dispositif électrochrome ce qui facilite la mise sous tension du dispositif.
De nombreuses mesures ont permis d'optimiser l'épaisseur de la couche. Préférentiellement, une couche comprenant de l'or d'une épaisseur comprise entre 27 et 50 nm permet d'obtenir un bon contact électrique.
Les s-RIPs POE/PEDOT 11 métallisés sur les deux faces sont ensuite gonflés de liquide ionique servant d'électrolyte.
Le gonflement a lieu durant 3 jours en pressant le s-RIP POE/PEDOT/Au entre plaques de Pétri surmontées d'un poids. Le taux de gonflement des s-RIPs POE/PEDOT/Au varie en fonction de l'épaisseur des couches métalliques. Ainsi, le taux de gonflement le plus élevé est obtenu pour un s-RIP POE/PEDOT recouvert de couches comprenant de l'or d'une épaisseur de 6 nm pour la première couche et de 27 nm pour la deuxième couche comprenant de l'or.

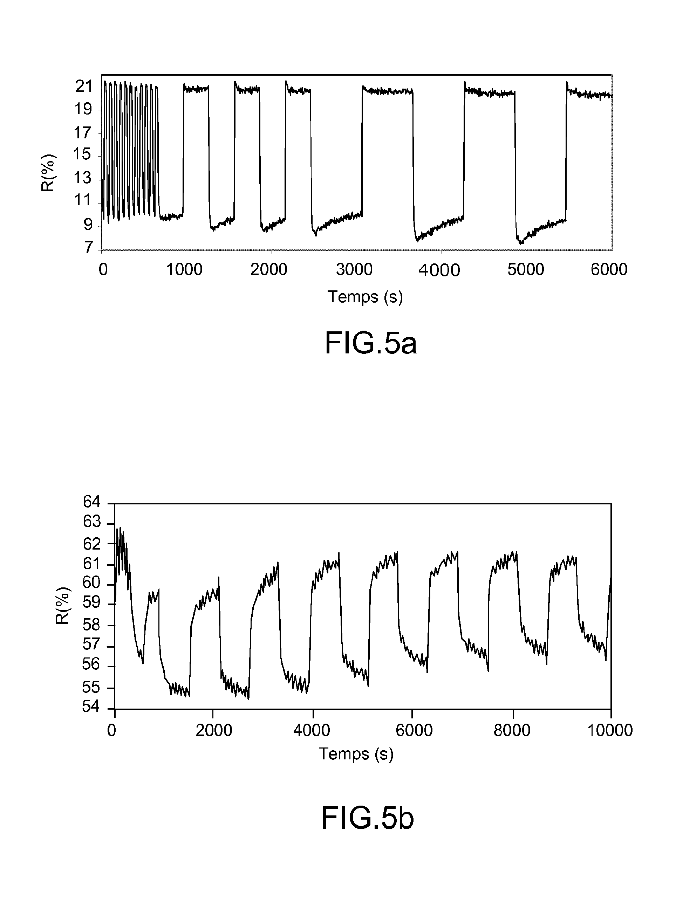

Les figures 5a et 5b représentent les spectres de caractérisation des performances optiques des dispositifs POE/PEDOT/Au gonflés d'EMITFSI.

Les performances optiques des dispositifs POE/PEDOT/Au gonflé d'EMITFSI sont évaluées sur la figure 5a lors de leurs changements d'état d'oxydoréduction. Ce changement est obtenu par commutation électrochimique entre l'état réduit où le matériau est absorbant dans le domaine de l'infrarouge et l'état oxydé où le matériau est réflecteur dans l'infrarouge.

Les potentiels appliqués sont de +/- 1,2 V durant des périodes de temps variables de 30 secondes jusqu'à 10 minutes.

La figure 5a montre qu'une surface radiative comprenant un s-RIP POE/PEDOT dont la face en contact avec les rayonnements solaires est recouverte d'une couche métallique de 6 nm et gonflé à l'EMITFSI présente une réflectivité maximale à 2500 nm de 21% à l'état oxydé et une réflectivité minimale à 2500 nm de 8 à 9 % à l'état réduit. Ce type de dispositif permet une variabilité de réflectivité d'environ 10 %. Par ailleurs, le temps de commutation de l'état réduit à l'état oxydé observé pour ces premiers matériaux est de 30 secondes environ.

La figure 5b montre qu'une surface radiative comprenant un s-RIP POE/PEDOT dont la face en contact avec les rayonnements solaires est recouverte d'une couche métallique de 27 nm et gonflé à l'EMITFSI présente une réflectivité maximale à 2500 nm de 60% à l'état oxydé et une réflectivité minimale à 2500 nm de 55 à 57% à l'état réduit. Ce type de dispositif permet une variabilité de réflectivité d'environ 3 à 5 %. La figure 5b montre bien que l'augmentation de l'épaisseur de la couche comprenant de l'or diminue l'absorptivité des rayonnements solaires mais cela est au détriment de l'amplitude de la variation de l'émissivité.
Les figure 5a et 5b montrent en outre qu'une couche métallique sur la surface directement en contact avec les rayonnements solaires n'empêche pas la commutation du s-RIP POE/PEDOT.

## Revendications

1. Surface radiative comportant :
- un film comprenant :
○ un réseau semi-interpénétré ou interpénétré d'un premier polymère conducteur ionique et d'un deuxième polymère conducteur électronique et électro-chrome ;
○ un électrolyte pour imprégner ledit réseau,
- ledit film comprenant une première face destinée à être en contact avec les rayonnements solaires, ladite première face étant recouverte d'une première couche métallique afin de diminuer l'absorptivité des rayonnements solaires.

2. Surface radiative selon la revendication 1, **caractérisée en ce que** la première couche métallique présente une épaisseur comprise entre environ quelques nanomètres et quelques dizaines de nanomètres.

3. Surface radiative selon l'une des revendications 1 ou 2, dans laquelle le premier polymère conducteur ionique comprend du polyoxyéthylène (POE).

4. Surface radiative selon l'une des revendications 1 à 3, dans laquelle le deuxième polymère conducteur électronique et électrochrome comprend du poly (3,4-éthylènedioxythiophène) (PEDOT).

5. Surface radiative selon l'une des revendications 1 à 4, dans laquelle la première couche métallique comprend de l'or, de l'argent ou de l'aluminium.

6. Surface radiative selon la revendication 5, dans laquelle la première couche comprenant de l'or a une épaisseur comprise entre 2,5 et 21 nm.

7. Surface radiative selon l'une des revendications précédentes dans laquelle le réseau semi-interpénétré ou interpénétré comprend en outre au moins une deuxième couche métallique sur sa deuxième face.

8. Surface radiative selon la revendication 7 dans laquelle la deuxième couche métallique comprend de l'or, de l'argent ou de l'aluminium.

9. Surface radiative selon la revendication 8 dans laquelle la deuxième couche comprenant de l'or a une épaisseur comprise entre 27 et 50 nm.

10. Surface radiative selon l'une des revendications précédentes dans laquelle l'électrolyte est un liquide ionique.

11. Surface radiative selon la revendication 10 dans laquelle l'électrolyte est du (1-éthyl-3-méthyl-imidazolium bis (trifluorométhanesulfonyl)imide) ou EMITFSI.

12. Procédé d'élaboration d'une surface radiative selon l'une des revendications 1 à 11 **caractérisé en ce qu'il** comprend les étapes suivantes :
- l'élaboration d'un réseau semi-interpénétré ou interpénétré comprenant :
○ un premier réseau de polymère conducteur ionique et
○ un deuxième polymère ou réseau de polymère, conducteur électronique et électrochrome,
- l'élaboration par évaporation thermique de la première couche métallique sur la face du réseau en contact avec le rayonnement solaire,
- l'imprégnation du réseau par l'électrolyte.

13. Procédé selon la revendication 12, comprenant en outre une étape d'élaboration d'une deuxième couche métallique sur la deuxième face de la surface radiative.
